# EUROPEAN PATENT APPLICATION

(11) **EP 2 289 861 A1**
(43) Date of publication of application: **02.03.2011**
(21) Application number: 09732179.8
(22) Date of filing: 06.04.2009
(51) Int. Cl.: C04B 35/83, C04B 41/88, C30B 15/10, H01L 23/36, H01L 23/373

(54) **CARBON FIBER CARBON COMPOSITE MOLDED BODY, CARBON FIBER-REINFORCED CARBON COMPOSITE MATERIAL AND MANUFACTURING METHOD THEREOF**

(30) Priority: 14.04.2008 JP 2008104539
(71) Applicant: Toyo Tanso Co., Ltd., Osaka-shi Osaka 555-0011 (JP)
(72) Inventor: TAKEDA, Akiyoshi, Kanonji-shi Kagawa 769-1612 (JP)
(74) Representative: Merkle, Gebhard
(86) International application number: PCT/JP2009/001583
(87) International publication number: WO 2009/128215

(57) **Abstract**

To obtain a carbon fiber-reinforced carbon composite material exhibiting excellent thermal conductivity in every direction in the plane containing the X and Y axes. A carbon fiber-carbon composite formed body in which a number of sheet-like dispersions containing pitch-based carbon fibers dispersed therein randomly in the plane containing the X and Y axes are laminated into a carbon fiber laminate, and pyrolytic carbon is deposited on the surfaces of the carbon fibers of the carbon fiber laminate to coat around the carbon fibers, whereby the carbon fiber laminate is filled with the pyrolytic carbon, and a carbon fiber-reinforced carbon composite material obtained using the carbon fiber-carbon composite formed body.

## Description

### TECHNICAL FIELD

This invention relates to a carbon fiber-carbon composite formed body, a carbon fiber-reinforced carbon composite material and a manufacturing method thereof.

### BACKGROUND ART

In the field of electronic devices using silicon or compound semiconductors, significant technology advances are being achieved, and the frequency and power conversion capacity used are expected to further increase. Along with this, the quantity of heat produced from electronic devices continues to increase. Therefore, so-called heat sink materials capable of helping electronic devices dissipate a greater quantity of heat at a higher rate according to the design are becoming more and more essential.

Among the materials currently used as heat sink materials are copper molybdenum, copper tungsten and aluminum nitride. The thermal conductivities of these heat sink materials are lower than 250 W/mK. Because of the above-mentioned advances in semiconductor technology, there is demand for materials having higher thermal conductivities than copper and silver (400 W/mK) .

The above-mentioned semiconductor devices are bonded to the above heat sink materials, such as by solder or silver brazing. Solder and silver brazing materials have low thermal conductivities of tens of W/mK. In addition, heat resistance occurs owing to bonding at the interface. Therefore, the actual thermal conductivity is reduced several ten percent from the original value owing to the bonding. Hence, the thermal conductivity required for such a heat sink material is needed to be 450 W/mK or more, preferably 500 W/mK or more, in consideration of loss in thermal conductivity at the interface.

Among the known materials having high thermal conductivities are those composed of diamond components, and graphite sheet. However, the thickness of these materials that can be attained by manufacturing is only about a few millimeters, and these materials are therefore subject to some restriction in the heat sink design phase. In addition, diamond components have the problem of high cost.

Among the other known materials having high thermal conductivities are carbon fiber-reinforced carbon composite materials. The known carbon fiber-reinforced carbon composite materials include those obtained by using a prepreg prepared from carbon fibers and a matrix precursor, such as resin, hot-pressing the prepreg and then graphitizing it, and those formed by carbonizing a matrix precursor in a prepreg, then containing pyrolytic carbon in the prepreg and then graphitizing the prepreg (see for example Patent Literatures 1 and 2).

The carbon fiber-reinforced carbon composite materials formed by the above methods significantly differ in thermal conductivity depending on the configuration of paralleling of carbon fibers, i.e., the structure of a so-called carbon fiber preform. The reason for this is that the degree of inclusion of pyrolytic carbon significantly depends on the paralleling direction, density and presence or absence of waves of carbon fibers. For example, it is attributed to the fact that the phenomenon that by thermal decomposition of organic gas, such as methane, ethane, ethylene or propane, carbon components thereof and part of hydrogen are deposited on the surfaces of carbon fibers is applied to the production of pyrolytic carbon. The frequency of collision of gas with the carbon fibers is significantly influenced by the structure and density of the preform. The gas sometimes may not reach the inside of the preform because the majority of gas decomposition is completed in the vicinity of the surface of the preform. Even if the gas reaches the inside of the preform, a sufficiently high thermal conductivity may not be achieved because the crystalline morphology of pyrolytic carbon formed differs depending on the type of carbon fibers.

Examples of specific configurations of paralleling of carbon fibers include (1) a configuration of carbon fibers paralleled in a single direction, (2) a configuration of carbon fibers paralleled in two directions (including woven configurations, such as a plain weave configuration and a satin weave configuration), and (3) a configuration of felt obtained by distributing carbon fibers into the X-, Y- and Z-axis directions and weaving them.

In the case (1), the resultant composite material achieves a thermal conductivity of 700 W/mK or more in the paralleling direction of carbon fibers. In the configuration of the case (3), the composite material achieves thermal conductivities of 300 to 400 W/mK in three directions of the X, Y and Z axes.

As described previously, carbon fiber-reinforced carbon composite materials are used as heat sink materials. Such a heat sink material for dissipating heat produced from a semiconductor is generally provided on a base, and the semiconductor is placed on the heat sink material. Heat produced in the semiconductor is transferred through the heat sink material to the base. In order to efficiently transfer to the base heat produced by heat generation of the semiconductor, it is important that heat conduct through the heat sink material while radially spreading throughout it.

If in the configuration of carbon fibers paralleled in a single direction as in the case (1), the heat sink material is placed so that the carbon fibers are oriented perpendicularly to the semiconductor, the direction of the carbon fibers is the direction in which the carbon fibers have a thermal conductivity of 700 W/mK or more, and downward heat conduction can therefore be rapidly performed. However, heat spread to the base cannot be expected, which makes it difficult to rapidly transfer heat produced in the semiconductor to the base.

On the other hand, if the heat sink material is placed so that the direction of the carbon fibers is parallel to the semiconductor, this makes it difficult to conduct heat from the semiconductor because the thermal conductivity of the carbon fibers in a direction perpendicular to the axis of the carbon fibers is 100 W/mK or less.

As for the configuration of carbon fibers in the case (3), there has been nothing reported regarding the average value of thermal conductivities in each of the X- and Y-axis directions being above 400 W/mK, and the configuration is therefore lacking in absolute thermal conductivity.

It can be assumed that a heat sink material having the configuration of carbon fibers paralleled in two directions in the case (2), the plain weave configuration or the satin weave configuration, based on the premise that it will achieve high thermal conductivities in two direction, can conduct heat from the semiconductor preferentially in vertical and transverse directions and can conduct heat while radially spreading heat throughout it. Such a heat sink material is less likely to conduct heat in the remaining one of the three directions. However, because a heat-vulnerable device often exists around a semiconductor, the device can be protected from heat by directing the direction in which heat of the heat sink material is less likely to conduct towards the device by design.

However, carbon fiber-reinforced carbon composite materials having such a configuration of carbon fibers paralleled in two directions as in the case (2) have not yet achieved a sufficiently high thermal conductivity, and have a problem in that the thermal conductivity is anisotropic in the plane containing the X and Y axes. For example, the carbon fiber-reinforced carbon composite materials have a problem in that the thermal conductivities in intermediate directions between the X and Y axes are lower than those in the X- and Y-axis directions.

### CITATION LIST

### PATENT LITERATURE

Patent Literature 1: Published Japanese Patent Application No. 2004-23088
Patent Literature 2: Published Japanese Patent Application No. 2004-91256

### SUMMARY OF INVENTION

An object of the invention is to provide a carbon fiber-carbon composite formed body and a carbon fiber-reinforced carbon composite material which are capable of achieving excellent thermal conductivity in every direction in the plane containing the X and Y axes, and a manufacturing method thereof.

A carbon fiber-carbon composite formed body of the present invention is characterized in that pyrolytic carbon is deposited on the surfaces of carbon fibers dispersed in a carbon fiber laminate randomly in the plane containing the X and Y axes to coat around the carbon fibers, whereby the carbon fiber laminate is filled with the pyrolytic carbon.

In the present invention, a carbon fiber laminate containing carbon fibers dispersed therein randomly in the plane containing the X and Y axes is used as a carbon fiber laminate to be filled with pyrolytic carbon. Since carbon fibers exist in random directions in the plane containing the X and Y axes, the thermal conductivity anisotropy in the plane containing the X and Y axes is small, thereby achieving excellent thermal conductivity in every direction in the plane.

The carbon fiber laminate in the present invention is preferably a number of laminated sheet-like dispersions in which carbon fibers are dispersed randomly in the plane containing the X and Y axes, or a mat-like dispersion that will be hereinafter described. Furthermore, the carbon fibers used in the carbon fiber laminate are preferably pitch-based carbon fibers. With the use of pitch-based carbon fibers, a coating layer of pyrolytic carbon having a concentric, dense onion structure along the periphery of each carbon fiber can be formed on the surface of the carbon fiber. By subjecting the concentric coating layer to heat treatment to graphitize it, a six-membered ring structure of graphite can be generated along the length direction of each carbon fiber, whereby graphite crystals can be grown in the length direction of the carbon fiber. Therefore, a high thermal conductivity can be achieved in the length direction of the carbon fiber.

Furthermore, the carbon fiber laminate in the present invention is a carbon fiber laminate having a high void content, and a large amount of pyrolytic carbon can therefore be deposited on the surfaces of the carbon fibers. Thus, the carbon fiber laminate can be filled with a large amount of pyrolytic carbon, and easily graphitizable pyrolytic carbon can be contained in large amounts in the carbon fiber laminate. Therefore, the carbon fiber laminate can achieve a high thermal conductivity. For example, the carbon fiber laminate can be filled with pyrolytic carbon in an amount five to ten times the amount of carbon fibers in volume ratio.

The carbon fibers used in the carbon fiber laminate in the present invention are preferably pitch-based carbon fibers and more preferably their short fibers. For example, the carbon fibers preferably have a length of 10 to 150 mm and more preferably have a length of 30 to 100 mm. Such short fibers can be manufactured by cutting commercially available carbon fibers. The average diameter of the carbon fibers is preferably within the range of 8 to 12 µm. The density is preferably 1.50 to 2.00 Mg/m³.

The deposition of pyrolytic carbon in the present invention can be implemented by conventionally known methods. For example, pyrolytic carbon can be deposited on the surfaces of the carbon fibers by thermally decomposing a hydrocarbon gas having a carbon number of 1 to 8, preferably a carbon number of 3, or a hydrocarbon compound having a carbon number of 1 to 8, preferably a carbon number of 3, such as a compound of hydrocarbon and halogen. The hydrocarbon gas and the hydrocarbon compound gas are preferably used diluted with hydrogen gas or the like. In this case, the hydrocarbon concentration is preferably 5% to 15% by volume. The treatment temperature is 1300°C or below, and the pressure is 100 Torr or below, and preferably 50 Torr or below. If the treatment temperature is above 1300°C, pyrolytic carbon reacts in gas phase and may not be able to be introduced into the deep part of the carbon fiber laminate. Furthermore, if the pressure is above 100 Torr, the distance of the mean free path of the source gas becomes long, whereby the diffusion of the gas into the carbon fiber laminate becomes poor and pyrolytic carbon may not be able to be introduced into the deep part of the carbon fiber laminate.

For the deposition of pyrolytic carbon, conventional methods can be employed, such as an isothermal method, a temperature gradient method, a pressure gradient method or a pulse method. The method and conditions in depositing pyrolytic carbon are of little importance, and any method can be used so long as it can fill the deep part of the carbon fiber laminate with pyrolytic carbon.

The carbon fiber laminate in the present invention is, as described previously, a carbon fiber laminate containing carbon fibers dispersed therein randomly in the plane containing the X and Y axes . Such a carbon fiber laminate can be manufactured, for example, by impregnating a dispersion having carbon fibers dispersed therein randomly in the plane containing the X and Y axes with resin to prepare a prepreg, laminating a plurality of the prepregs, pressing the plurality of the prepregs into a certain form, and subjecting the form to heat treatment. Alternatively, such a carbon fiber laminate can be manufactured by allowing resin to adhere to the surfaces of carbon fibers by application of resin thereto, impregnation thereof with resin or immersion thereof into resin, dispersing the carbon fibers randomly in the plane containing the X and Y axes to prepare a dispersion, laminating a plurality of the dispersions, pressing the dispersions into a certain form, and subjecting the form to heat treatment. In these cases, in order to increase the thermal conductivity of the carbon fiber-reinforced carbon composite formed body, pitch-based carbon fibers are preferably used as the carbon fibers.

In a method for producing the carbon fiber laminate, for example, 20 to 70 parts by mass of resin is applied to 100 parts by mass of the dispersion of carbon fibers and then dried. The content of resin is more preferably 20 to 50 parts by mass. In the case of using prepregs, the thickness of each prepreg is preferably within the range of 0. 1 to 2.0 mm and more preferably within the range of 0.1 to 1.0 mm. A plurality of such prepregs are laminated and then pressed into a certain form. The number of prepregs laminated is preferably 10 to 100. The pressing is preferably performed with a hot press. The pressure is preferably 0.01 MPa or above and more preferably 0.3 MPa or above. The temperature in pressing is preferably within the range of 100°C to 300°C. The temperature is more preferably 100°C to 200°C.

In another method for producing the carbon fiber laminate, a mat-like dispersion can be obtained by carding short carbon fibers and then matting them with a binder. A binder that can be suitably used is an organic binder. Note that a mat-like dispersion producing a difference in carbon fiber density, like a typical molded insulation, and a mat-like dispersion containing carbon fibers oriented in three dimensions by a needlepunch process are not preferable. The preferred mat-like dispersion that can be used is one having a configuration in which carbon fibers are dispersed randomly in the plane containing the X-axis and the Y-axis and having a carbon fiber density difference as small as possible. In short, the carbon fiber laminate can be formed of a mat-like dispersion obtained by carding short carbon fibers and matting them with a binder. Such a mat-like dispersion has a thick dispersion and can therefore be used as a carbon fiber laminate as it is. As thus far described, an essential point of the present invention is to use a carbon fiber laminate having a configuration in which carbon fibers are dispersed randomly in the plane containing the X-axis and the Y-axis.

The density of the carbon fiber laminate is preferably within the range of 0.1 to 0 .4 Mg/m³. If the density of the carbon fiber laminate is too low, this often involves damages to the laminate in the later process steps to make it impossible to retain the shape. If the density of the carbon fiber laminate is too high, this makes it difficult to deposit pyrolytic carbon to the inside of the carbon fiber laminate.

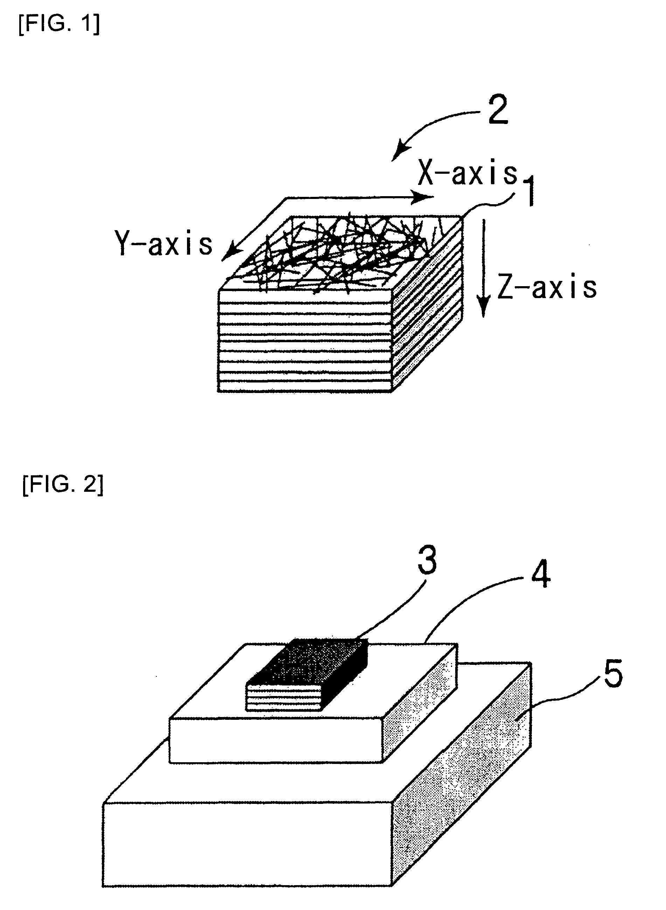

FIG. 1 is a schematic view showing an example of the carbon fiber laminate in the present invention. As shown in FIG. 1, a carbon fiber laminate 2 is formed by laminating a number of sheet-like dispersions 1 in which pitch-based carbon fibers are dispersed randomly in the plane containing the X-axis and the Y-axis.

The density of the carbon fiber-carbon composite formed body after the filling of the carbon fiber laminate or the molded carbon fiber laminate with pyrolytic carbon is preferably 1.50 to 1.80 Mg/m³. If the density of the carbon fiber-carbon composite formed body is too low, the resultant thermal conductivity becomes low. If the density thereof is too high, the density difference between the inside and outer periphery of the carbon fiber-carbon composite formed body becomes large.

The crystals of each carbon fiber subjected to heat treatment preferably form an onion structure, and the thickness of pyrolytic carbon deposited on the carbon fiber is preferably greater than the diameter of the section of the carbon fiber. If the thickness of pyrolytic carbon is smaller than the diameter of the section of the carbon fiber, the density of the carbon fiber-reinforced carbon composite formed body becomes low, so that the resultant thermal conductivity becomes low.

In the present invention, after the filling of pyrolytic carbon in the above manner, the carbon fiber-carbon composite formed body is preferably further impregnated with pitch. By impregnating the carbon fiber-carbon composite formed body with pitch, it can be given mechanical strength. The pitch with which the carbon fiber-carbon composite formed body is thus impregnated acts as a binder therein and can cover the relatively brittle pyrolytic carbon coating layers and fill in voids in the carbon fiber-carbon composite formed body. The density of the carbon fiber-carbon composite formed body after being impregnated with pitch is preferably 1.60 to 2.00 Mg/m³. If the density is too low, the thermal conductivity becomes low. If the density is to be increased over the above range, special facilities will be necessary, which is impractical.

A carbon fiber-reinforced carbon composite material of the present invention is characterized by being obtained by subjecting the carbon fiber-carbon composite formed body of the present invention impregnated with pitch to heat treatment, thereby growing graphite crystals of the carbon fiber-carbon composite formed body.

Since the carbon fiber-reinforced carbon composite material of the present invention is one obtained by growing graphite crystals of the carbon fiber-carbon composite formed body of the present invention after being impregnated with pitch, it contains graphite crystals grown in a good condition along the direction of each carbon fiber and can thereby achieve excellent thermal conductivity.

Furthermore, since the carbon fiber-reinforced carbon composite material uses a carbon fiber-carbon composite formed body in which carbon fibers are dispersed randomly in the plane containing the X-axis and the Y-axis, it can achieve high thermal conductivity in every direction in the plane containing the X-axis and the Y-axis.

The heat treatment temperature in subjecting the carbon fiber-carbon composite formed body to heat treatment to grow graphite crystals is preferably 2800°C or above, and more preferably within the range of 2800°C to 3100°C. If the heat treatment temperature is too low, the growth of graphite crystals is insufficient, resulting in low thermal conductivity.

In the carbon fiber-reinforced carbon composite material after the growth of graphite crystals, the thickness of the graphite crystal between adjacent (112) planes determined by X-ray diffraction is preferably 6 nm or more. The more preferred thickness thereof is 8 mm or more.

If the thickness of the graphite crystal between adjacent (112) plane determined by X-ray diffraction is 6 nm or more, high thermal conductivity can be achieved.

The carbon fiber-reinforced carbon composite material of the present invention can achieve, for example, a value of 450 W/mK or more as the thermal conductivity in the plane containing the X-axis and the Y-axis. Furthermore, for example, a value of 50 to 200 W/mK can be achieved as the thermal conductivity in the Z-axis direction.

A method for manufacturing a carbon fiber-reinforced carbon composite material according to the present invention is a method that can manufacture the carbon fiber-reinforced carbon composite material of the present invention, and includes the steps of: preparing the carbon fiber laminate having a density of 0.1 to 0.4 Mg/m³ using pitch-based carbon fibers; depositing pyrolytic carbon on the surfaces of the carbon fibers of the carbon fiber laminate, thereby preparing a carbon fiber-carbon composite formed body having a density of 1.50 to 1.80 Mg/m³; impregnating the carbon fiber-carbon composite formed body with pitch until the density thereof reaches 1.60 to 2.00 Mg/m³; and subjecting the carbon fiber-carbon composite formed body impregnated with pitch to heat treatment until the thickness of the graphite crystal between adjacent (112) planes determined by X-ray diffraction reaches 6 nm or more.

According to the present invention, since the carbon fiber-reinforced carbon composite material of the present invention is manufactured using the carbon fiber-carbon composite formed body of the present invention, there can be provided a carbon fiber-reinforced carbon composite material having excellent thermal conductivity in every direction in the plane containing the X-axis and the Y-axis.

A heat sink material of the present invention is characterized by using the carbon fiber-reinforced carbon composite material of the present invention or a carbon fiber-reinforced carbon composite material manufactured by the manufacturing method of the present invention.

Since the heat sink material of the present invention uses the carbon fiber-reinforced carbon composite material of the present invention or a carbon fiber-reinforced carbon composite material manufactured by the manufacturing method of the present invention, it exhibits excellent thermal conductivity in every direction in the plane containing the X-axis and the Y-axis. Therefore, the heat sink material can be suitably used as a heat sink material for cooling a semiconductor device.

Furthermore, the heat sink material of the present invention may be one in which the carbon fiber-reinforced carbon composite material of the present invention is impregnated with a molten metal.

By impregnating the carbon fiber-reinforced carbon composite material with a molten metal, the voids in the carbon fiber-reinforced carbon composite material can be further reduced, thereby enhancing the bondability to metal, such as terminals of electronic components. Examples of such a molten metal include copper and aluminum alloy.

The metal impregnation in the present invention can be implemented by conventionally known methods. For example, the metal impregnation can be achieved by melting oxygen-free copper in an inert gas atmosphere, immersing the carbon fiber-reinforced carbon composite material into the molten copper and applying a pressure of 1 to 10 MPa.

Furthermore, the heat sink material of the present invention may be one obtained by coating the surface of the carbon fiber-reinforced carbon composite material of the present invention or the surface of the carbon fiber-reinforced carbon composite material impregnated with a molten metal with iron, copper, aluminum, iron alloy, copper alloy or aluminum alloy.

The coating with iron, copper, aluminum, iron alloy, copper alloy or aluminum alloy in the present invention can be implemented by conventionally known methods. For the coating, conventional methods can be employed, such as nonelectrolytic plating or electroplating.

Examples of such plating methods include electroplating in which current is passed through an aqueous solution containing ionized metal to precipitate metal on the surface of a material by electrochemical redox reaction, nonelectrolytic plating in which a compound containing a metal to be precipitated and a reductant are dissolved in a solution and a material is immersed into the solution to precipitate the metal on the surface of the material, and immersion plating using a difference in ionization tendency (potential difference) between different kinds of metals.

Any method and conditions for the coating with iron, copper, aluminum, iron alloy, copper alloy or aluminum alloy can be used so long as it can meet the usage environment of the heat sink material.

### (Advantageous Effects of Invention)

By forming the carbon fiber-reinforced carbon composite material of the present invention using the carbon fiber-carbon composite formed body of the present invention, there can be provided a carbon fiber-reinforced carbon composite material exhibiting excellent thermal conductivity in every direction in the plane containing the X-axis and the Y-axis.

According to the manufacturing method of the present invention, a carbon fiber-reinforced carbon composite material can be manufactured which exhibits excellent thermal conductivity in every direction in the plane containing the X-axis and the Y-axis.

Since the heat sink material of the present invention uses the carbon fiber-reinforced carbon composite material of the present invention, it exhibits excellent thermal conductivity in every direction in the plane containing the X-axis and the Y-axis.

### BRIEF DESCRIPTION OF DRAWINGS

[FIG. 1] FIG. 1 is a schematic perspective view showing a carbon fiber laminate according to the present invention.
[FIG. 2] FIG. 2 is a perspective view showing a structure in which a heat sink material is disposed between a semiconductor device and a base.
[FIG. 3] FIG. 3 is a scanning electron micrograph showing a cross section of a carbon fiber-reinforced carbon composite material in an example according to the present invention.

### DESCRIPTION OF EMBODIMENTS

Hereinafter, the present invention will be described with reference to specific examples. However, the present invention is not limited by the following examples.

### (Example 1)

Pitch-based carbon fibers (a yarn of 12000 (12K) filaments, average diameter: 9 µm, density: 1.93 Mg/m³) were cut into lengths of about 30 to 100 mm, and a sizing agent was removed therefrom using acetone or the like. The carbon fibers were dispersed in random directions, and then bonded together with 30 parts by mass of phenol resin relative to 100 parts by mass of carbon fibers, thereby preparing sheet-like prepregs (thickness: approximately 0.5 mm) in which the carbon fibers were dispersed randomly in the plane containing the X and Y axes. The prepregs were preliminarily dried in an oven at approximately 100°C. Approximately 100 prepregs after being dried were laminated and pressed into a certain form using a hot press under the conditions of a pressure of 0.3 MPa and a temperature of 150°C. Next, the form was subjected to heat treatment at approximately 2000°C, thereby obtaining a carbon fiber laminate having a size of 50 mm x 50 mm x 50 mm. The density of the carbon fiber laminate was 0.15 Mg/m³.

Contained in the carbon fiber laminate was pyrolytic carbon having an easily graphitizable rough columnar structure. Specifically, pyrolytic carbon was deposited on the surfaces of carbon fibers constituting the carbon fiber laminate to coat around the carbon fibers, whereby the carbon fiber laminated was filled with pyrolytic carbon. The density of the resultant carbon fiber-carbon composite formed body after the filling of pyrolytic carbon was 1.65 Mg/m³.

Next, the carbon fiber-carbon composite formed body filled with pyrolytic carbon in the above manner was impregnated with easily graphitizable hot pitch. By repeating the impregnation and the subsequent heat treatment five times, the carbon fiber-carbon composite formed body was impregnated with the pitch. The density of the carbon fiber-carbon composite formed body after the end of impregnation with pitch was 1.85 Mg/m³.

After the end of impregnation with pitch in the above manner, the carbon fiber-carbon composite formed body was subjected to heat treatment at approximately 3000°C and thereby graphitized.

TABLE 1 shows densities and volume fractions of carbon fiber laminates, densities and volume fractions thereof after being filled with pyrolytic carbon, densities and volume fractions thereof after being impregnated with pitch, densities thereof after being subjected to heat treatment for graphitization, crystal thicknesses d of graphite crystals between adjacent (112) planes, and thermal conductivities of carbon fiber-reinforced carbon composite materials after being subjected to heat treatment for graphitization. Note that the density is that after the completion of each process step, and the volume fraction is expressed as percentage by volume. The density after the completion of each process step, the interplanar spacing d between adjacent (112) planes and the thermal conductivity were determined in the following manners.

### [Determination of Density]

A specimen having a size of 10 mm x 10 mm x 60 mm was cut out of the carbon fiber-reinforced carbon composite material, and its surface was finished more smoothly than a surface roughness Rz of 12 µm. In this condition, the mass of the specimen was measured with a weighing machine, and the dimensions thereof were measured with a micrometer. The dimensions in three directions were multiplied to obtain the volume. The density was determined by dividing the mass by the volume.

### [Determination of Thermal Conductivity]

The thermal conductivity was determined from the following formula according to JIS (Japanese Industrial Standards) R1611-1997: Thermal Conductivity = (Thermal Diffusivity) x (Specific Heat Capacity) x (Bulk Density). A specimen with a diameter of 10 mm and a length of 3 mm was prepared, and its thermal diffusivity was measured with a laser flash method thermal constant measuring system (TC-7000UVH) manufactured by ULVAC-RIKO, Inc.

The specific heat capacity was determined from "New Introduction to Carbon Materials (edited by The Carbon Society of Japan, page 45, TABLE 1, Thermodynamic Functions for Graphite)".

The term "Dirs. in X-Y Plane" for the thermal conductivity shown in TABLE 1 refers to the minimum thermal conductivity to the maximum thermal conductivity when determined in every direction in the plane containing the X-axis and Y-axis. The term "Z-Axis Dir." refers to the thermal conductivity in the Z-axis direction.

### [Determination of Crystal Structure (Interplanar Spacing d(112))]

The crystal structure was determined by the Gakushin method by using an X-ray diffractometer to monochromate Cu K alpha radiation with a Ni filter and using high-purity silicon as a reference material. The determination of the distance d between adjacent (112) planes of graphite crystal was made by forming the carbon fiber-reinforced carbon composite material into powder and using the powder.

### (Example 2)

A carbon fiber laminate was filled with pyrolytic carbon in the same manner as in Example 1, then repeatedly subjected to immersion into an easily graphitizable pitch of low quinoline insoluble content and heat treatment, and thereafter subjected to heat treatment for graphitization.

The density of the carbon fiber laminate was 0.25 Mg/m³, the density thereof after being filled with pyrolytic carbon was 1.75 Mg/m³, and the density thereof after being subjected to immersion into pitch and heat treatment was 1.82 Mg/m³. The crystal thickness d between adjacent (112) planes of graphite crystal after being subjected to graphitization treatment was 8 nm.

Determinations were made in the same manners as in Example 1, and the determination results are shown in TABLE 1.

### (Example 3)

Pyrolytic carbon was contained in a carbon fiber laminate in the same manner as in Example 1, and the carbon fiber laminate was then repeatedly subjected to immersion into a pitch and heat treatment, and then subjected to heat treatment for graphitization, thereby obtaining a carbon fiber-reinforced carbon composite material.

The density of the carbon fiber laminate was 0.20 Mg/m³, the density thereof after containing pyrolytic carbon was 1.75 Mg/m³, the density thereof after being impregnated with pitch was 1.95 Mg/m³, and the crystal thickness d between adjacent (112) planes of graphite crystal was 8 nm..

Determinations were made in the same manners as in Example 1, and the determination results are shown in TABLE 1.

### (Example 4)

Pyrolytic carbon was contained in a carbon fiber laminate in the same manner as in Example 1, and the carbon fiber laminate was then repeatedly subjected to immersion into a pitch and heat treatment, and thereafter subjected to heat treatment for graphitization. The density of the carbon fiber laminate was 0.25 Mg/m³, the density thereof after containing pyrolytic carbon was 1.65 Mg/m³, the density thereof after being subjected to immersion into pitch and heat treatment was 1.85 Mg/m³, and the crystal thickness d between adjacent (112) planes of graphite crystal after being subjected to heat treatment for graphitization was 8 nm..

Determinations were made in the same manner as in Example 1, and the determination results are shown in TABLE 1.

### (Example 5)

A carbon fiber laminate with a density of 0.20 Mg/m³ was filled with pyrolytic carbon to give a density of 1.50 Mg/m³. Next, the carbon fiber laminate was repeatedly subjected to immersion into coal tar pitch and heat treatment, so that the density thereof after immersion was 1.85 Mg/m³. Thereafter, the carbon fiber laminate was subjected to heat treatment for graphitization. The crystal thickness d between adjacent (112) planes of graphite crystal after being subjected to heat treatment for graphitization was 8 nm. The thermal conductivity in the X-Y plane of the resultant carbon fiber-reinforced carbon composite formed body was 400 to 450 W/(m·K), and the thermal conductivity in the Z-axis direction was 140 W/(m·K).

Results of determinations made in the same manners as in Example 1 are shown in TABLE 1.

### (Example 6)

A carbon fiber laminate with a density of 0.20 Mg/m³ was filled with pyrolytic carbon to give a density of 1.65 Mg/m³. Next, the carbon fiber laminate was repeatedly subjected to immersion into coal tar pitch and heat treatment, so that the density thereof after immersion was 1.85 Mg/m³. Thereafter, the carbon fiber laminate was subjected to heat treatment for graphitization. The crystal thickness d between adjacent (112) planes of graphite crystal after being subjected to heat treatment for graphitization was 6 nm. The thermal conductivity in the X-Y plane of the resultant carbon fiber-reinforced carbon composite formed body was 400 to 450 W/(m·K), and the thermal conductivity in the Z-axis direction was 100 W/(m·K).

Determinations were made in the same manner as in Example 1, and the determination results are shown in TABLE 1.

### (Example 7)

Short carbon fibers from pitch-based carbon fibers of Example 1, whose length was 30 to 100 mm, were subjected to carding and matted with an organic binder, thereby obtaining a 50 mm x 50 mm x 50 mm mat-like dispersion (with a density of 0.15 Mg/m³) in which the carbon fibers were dispersed randomly in the plane containing the X-axis and the Y-axis. The dispersion was filled with pyrolytic carbon having an easily graphitizable rough columnar structure to give a density of 1.65 Mg/m³. Next, the dispersion was repeatedly subjected to immersion into coal tar pitch and heat treatment, so that the density thereof after immersion was 1.85 Mg/m³. Thereafter, the dispersion was subjected to heat treatment for graphitization. The crystal thickness d between adjacent (112) planes of graphite crystal after being subjected to heat treatment for graphitization was 8 nm. The thermal conductivity in the X-Y plane of the resultant carbon fiber-reinforced carbon composite formed body was 450 to 550 W/ (m·K), and the thermal conductivity in the Z-axis direction was 140 W/(m·K).

Determinations were made in the same manner as in Example 1, and the determination results are shown in TABLE 1.

The surfaces of the carbon fiber-reinforced carbon composite materials of Examples 1 to 7 were coated with iron, copper, aluminum, iron alloy, copper alloy and aluminum alloy, respectively, by plating, thereby obtaining metal-coated carbon fiber-reinforced carbon composite materials. The obtained metal-coated carbon fiber-reinforced carbon composite materials were excellent in heat sink performance and suitable as heat sink materials.

### (Comparative Example 1)

A carbon fiber laminate with a density of 0.05 Mg/m³ was often damaged in the subsequent process steps and could not retain the shape.

### (Comparative Example 2)

A carbon fiber laminate with a density of 0.5 Mg/m³ was filled with pyrolytic carbon, but the density thereof was 1.00 Mg/m³ showing a small pyrolytic carbon content. Thereafter, the carbon fiber laminate was subjected to heat treatment at approximately 3000°C. However, the resultant carbon fiber-reinforced carbon composite formed body had a thermal conductivity of 100 W/(m·K) in the X-Y plane and a thermal conductivity of 10 W/(m·K) in the Z-axis direction.

**[TABLE 1]**

| **Item** | **Carbon Fiber Laminate** | | **After Filled with Pyrolytic Carbon** | | **After Impregnated with Pitch** | | **Density after Graphitization (Mg/m³)** | **d₁₁₂ (nm)** | **Thermal Conductivity** | |
|---|---|---|---|---|---|---|---|---|---|---|
| | **Density (Mg/m³)** | **Volume Fraction** (%) | **Density (Mg/m³)** | **Volume Fraction (%)** | **Density (Mg/m³)** | **Volume Fraction (%)** | | | **Dirs. in** X-Y **Plane (W/mK)** | **Z-Axis Dir. (W/mK)** |
| **Ex. 1** | 0.15 | 7 | 1.65 | 68 | 1.85 | 9 | 1.82 | 8 | 450~550 | 140 |
| **Ex. 2** | 0.25 | 12 | 1.75 | 71 | 1.82 | 5 | 1.80 | 8 | 450~650 | 120 |
| **Ex. 3** | 0.20 | 9 | 1.75 | 71 | 1.95 | 9 | 1.90 | 8 | 530~580 | 140 |
| **Ex. 4** | 0.25 | 12 | 1.65 | 68 | 1.85 | 9 | 1.81 | 8 | 500~550 | 140 |
| **Ex. 5** | 0.20 | 9 | 1.50 | 59 | 1.85 | 16 | 1.82 | 8 | 400~450 | 140 |
| **Ex. 6** | 0.20 | 9 | 1.65 | 68 | 1.85 | 9 | 1.81 | 6 | 400~450 | 100 |
| **Ex. 7** | 0.15 | 7 | 1.65 | 68 | 1.85 | 9 | 1.82 | 8 | 450~550 | 140 |
| **Comp. Ex. 1** | 0.05 | 3 | **Low Shape Retention, Damaged in the Course of Manufacturing** | | | | | | | |
| **Comp. Ex. 2** | 0.50 | 25 | 1.00 | 48 | - | - | 1.0 | - | 100 | 10 |

As shown in TABLE 1, the carbon fiber-reinforced composite materials of the present invention using carbon fiber laminates prepared from pitch-based carbon fibers according to the present invention achieved high thermal conductivity in every direction in the plane containing the X-axis and the Y-axis.

### [Observation with Scanning Electron Microscope (SEM)]

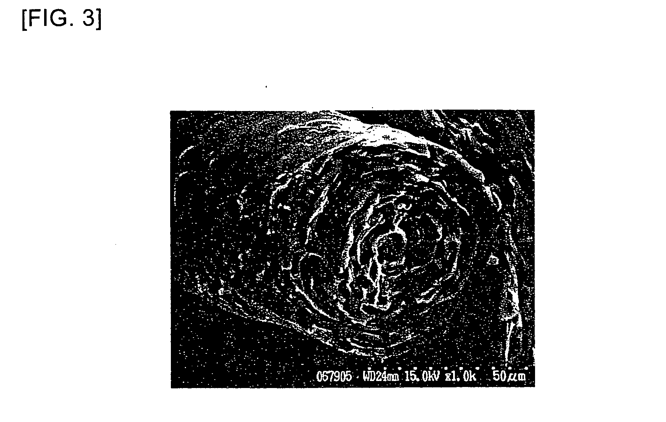

FIG. 3 is a SEM photograph showing a cross section of the carbon fiber-reinforced composite material of Example 2 according to the present invention. As shown in FIG. 3, in the example according to the present invention, a coating layer made of pyrolytic carbon is formed around a carbon fiber. The coating layer made of pyrolytic carbon has a concentric onion structure.

The carbon fiber-reinforced carbon composite material of the present invention manufactured in the manner as described above can be used as a heat sink material for cooling a semiconductor device as shown in FIG. 2. Furthermore, the carbon fiber-reinforced carbon composite material of the present invention may be used impregnated with a molten metal, such as aluminum alloy or copper.

FIG. 2 is a perspective view showing a state in which a semiconductor device 3 is placed over a base 5 with a heat sink material 4 interposed therebetween. As shown in FIG. 2, the heat sink material 4 is disposed between the base 5 and the semiconductor device 3. Heat produced from the semiconductor device 3 is transferred through the heat sink material 4 to the base 5.

### REFERENCE SIGNS LIST

- 1: sheet-like dispersion
- 2: carbon fiber laminate
- 3: semiconductor device
- 4: heat sink material
- 5: base

## Claims

1. A carbon fiber-carbon composite formed body in which pyrolytic carbon is deposited on the surfaces of carbon fibers dispersed in a carbon fiber laminate randomly in the plane containing the X and Y axes to coat around the carbon fibers, whereby the carbon fiber laminate is filled with the pyrolytic carbon.

2. The carbon fiber-carbon composite formed body of claim 1, wherein the carbon fiber laminate is a number of laminated sheet-like dispersions in which carbon fibers are dispersed randomly in the plane containing the X and Y axes.

3. The carbon fiber-carbon composite formed body of claim 2, wherein the carbon fiber laminate is obtained by impregnating a dispersion having carbon fibers dispersed therein randomly in the plane containing the X and Y axes with resin to prepare a prepreg, laminating a plurality of the prepregs, pressing the plurality of the prepregs into a certain form, and subjecting the form to heat treatment.

4. The carbon fiber-carbon composite formed body of claim 1, wherein the carbon fiber laminate is a mat-like dispersion obtained by carding carbon fibers and then matting the carbon fibers with a binder.

5. The carbon fiber-carbon composite formed body of any one of claims 1 to 4, wherein the carbon fibers are pitch-based carbon fibers.

6. The carbon fiber-carbon composite formed body of any one of claims 1 to 5, wherein the density is 1.50 to 1.80 Mg/m³.

7. The carbon fiber-carbon composite formed body of any one of claims 1 to 5, wherein after the filling of pyrolytic carbon, the carbon fiber-carbon composite formed body is impregnated with pitch.

8. The carbon fiber-carbon composite formed body of claim 7, wherein the density is 1.60 to 2.00 Mg/m³.

9. A carbon fiber-reinforced carbon composite material obtained by growing graphite crystals of the carbon fiber-carbon composite formed body of claim 7 or 8.

10. The carbon fiber-reinforced carbon composite material of claim 9, wherein the thickness of the graphite crystal between adjacent (112) planes determined by X-ray diffraction is 6 nm or more.

11. A method for manufacturing the carbon fiber-reinforced carbon composite material of claim 9 or 10, the method comprising the steps of:
preparing the carbon fiber laminate having a density of 0.10 to 0.40 Mg/m³;
depositing pyrolytic carbon on the surfaces of the carbon fibers of the carbon fiber laminate, thereby preparing a carbon fiber-carbon composite formed body having a density of 1.50 to 1.80 Mg/m³;
impregnating the carbon fiber-carbon composite formed body with pitch until the density thereof reaches 1.60 to 2.00 Mg/m³; and
subjecting the carbon fiber-carbon composite formed body impregnated with pitch to heat treatment until the thickness of the graphite crystal between adjacent (112) planes determined by X-ray diffraction reaches 6 nm or more.

12. A heat sink material using the carbon fiber-reinforced carbon composite material of claim 9 or 10 or using a carbon fiber-reinforced carbon composite material manufactured by the method of claim 11.

13. The heat sink material of claim 12, wherein the carbon fiber-reinforced carbon composite material is impregnated with a metal.

14. The heat sink material of claim 13, wherein the metal is copper or aluminum alloy.

15. A heat sink material obtained by coating the surface of the carbon fiber-reinforced carbon composite material or the surface of the heat sink material of claim 13 or 14 with a metal.

16. The heat sink material of claim 15, wherein the metal for coating is one or more selected from the group consisting of iron, copper, aluminum, iron alloy, copper alloy and aluminum alloy.
